# EUROPEAN PATENT APPLICATION

(11) **EP 2 315 242 A1**
(43) Date of publication of application: **27.04.2011**
(21) Application number: 09173913.6
(22) Date of filing: 23.10.2009
(51) Int. Cl.: H01L 23/14, H01L 23/15, H01L 23/373

(54) **Circuit arrangement and manufacturing method thereof**

(71) Applicant: ABB Technology AG, 8050 Zürich (CH)
(72) Inventor: Schulz, Nicola, CH-5300, Turgi (CH); Hartmann, Samuel, CH-5512, Wohlenschwil (CH)
(74) Representative: ABB Patent Attorneys

(57) **Abstract**

The present invention proposes a circuit arrangement of a power module, where a die is attached via an attachment layer to a metallization layer provided on an insulating substrate. The circuit arrangement furthermore comprises a base plate. The insulating substrate is made of a material providing a thermal expansion coefficient (CTE) of 10 µm/m-°C or above.

## Description

### Technical Field

The Invention relates to circuit arrangement, in particular in the field of power modules.

### Background Art

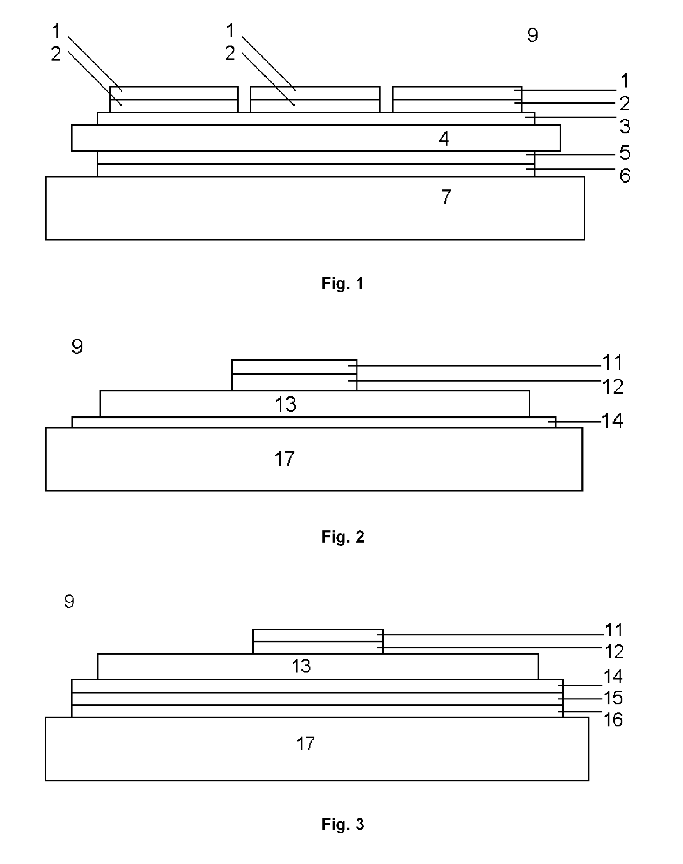

Known circuit arrangements - as shown in abstracted form in Figure 1 - comprise one or more dies 1 which is soldered 2 on a metallization 3, e.g. a copper layer. The metallization 3 is provided on a substrate 4 offering a certain thermal conductivity such as Aluminium nitride (AlN) or silicon nitride (Si₃N₄). The substrate 4 in turn is provided with another metallization 5, e.g. a copper layer, which is again soldered 6 on a base plate 7. The base plate 7 again offers a certain thermal conductivity and is typically made of an Aluminium Silicon Carbide (AlSiC).

However, in these arrangements certain disadvantages are to be experienced.

Both, substrate and base plate are made of a material offering a low coefficient of thermal expansion (CTE) in order to match the low CTE of the chip. Although using low CTE materials minimizes shear stress in the solder due to a CTE mismatch of the soldered components, in particular between substrate and die, during a power cycle, the costs involved by using these materials for substrate and base plate are rather high.

Another disadvantage which is even more severe pertains to the solder. The solder 2 and 6 typically possesses a higher CTE than both die 1 and metallization 3 and / or metallization 5 and base plate 7. This mismatch of CTEs leads to stress in the plane of the soldered surfaces. This stress, may lead to cracks, thereby negatively affecting the lifetime of such circuit arrangements. If the circuit arrangement is subject to large temperature changes such as in high swings, this effect gets even more severe.

If a ceramic based substrate 4 is used, such as an AlN substrate offering a low CTE of around 4.6 to 6.8 µm/m-°C , the metallization 3, 5 needs to be thin to reduce stress between the metallization 3, 5 and the substrate 4. In this context thin means 300 µm or less. Such thin metallization layers, however, put certain constraints on the development, since thin metallization layers do neither provide for a heat spreading nor allows for an optimized electrical resistance.

Still another disadvantage of these known circuit arrangements is that due to the plurality of thermal interfaces the overall thermal resistance towards a heat sink, is negatively affected which also may have detrimental effects towards the lifetime of this circuit arrangements.

### Summary of invention

It is therefore an object of the invention to provide an improved arrangement which shall obviate at least one of the disadvantages known in the art.

This object is achieved by a circuit arrangement of a power module, where a die is attached via an attachment layer to a metallization layer provided on an insulating substrate. The circuit arrangement furthermore comprises a base plate. The insulating substrate is made of a material providing a thermal expansion coefficient (CTE) of 10 µm/m-°C or above and the attachment layer is a low temperature bond (LTB).

Typically, a LTB possesses a significantly higher mechanical and thermal stability than a soldered connection. Therefore, the lifetime of the LTB connection e.g. between a semiconductor die (CTE of silicon: around 2.6 µm/m-°C) and a high-CTE (CTE ≥ 10 µm/m-°C) substrate is typically not lower than that of a soldered connection between a semiconductor die and a low-CTE substrate such as AlN substrate. Furthermore, the reliability of aluminium bond wires attached to the die's top surface may be improved since the die is forced to a higher effective CTE (being closer to the CTE of the bond wires) due to its strong mechanical coupling to the subjacent high-CTE materials via the LTB layer.

In a still further embodiment, the attachment layer comprises silver.

In yet another preferred embodiment, the metallization layer comprises copper.

According to another embodiment, the thickness of the metallization layer is in the range of 350 µm to 2 mm, and even more preferably in the range of 500 µm to 1.5 mm.

In a further preferred embodiment, the metallization comprises a noble metal coating on a surface.

Such a noble metal coating inhibits oxide layers offering a superior connection, in particular in connection with a low temperature bond.

According to still another embodiment, the base plate material is a metallic material, and even more preferably, the base plate material comprises Copper or Aluminium.

In yet another preferred embodiment, the insulating substrate is selected from a group comprising epoxy-based substrates, polymer-based substrates.

According to a preferred embodiment, the circuit arrangement is a low voltage power module.

According to another preferred embodiment, the CTE of the metallization layer provides a CTE of around 16 µm/m-°C and the insulating substrate provides a CTE in the range of 12 µm/m-°C to 20 µm/m-°C.

### Brief description of drawings

The invention is further detailed by figures, in which
Figure 1 shows a sketch of a circuit arrangement known in the art
Figure 2 shows a sketch of a first embodiment of a circuit arrangement according to the invention, and
Figure 3 shows a sketch of a second embodiment of a circuit arrangement according to the invention.

### Description of embodiments

In the following the invention will be further detailed with respect to the figures Fig. 2 and Fig. 3 in which like elements are referenced by the same reference signs. In order to not obscure the invention further elements pertaining to these circuit arrangements such as conductors for contacting gates, collectors, emitters, etc. or wire bonds or connection plates are not displayed.

Fig .2 displays an example of a circuit arrangement according to the invention.

In this first embodiment a die 11, typically a Si based chip die, is attached on a metallization 13. Although only one die is displayed in Fig. 2 and Fig. 3, a plurality of dies in a neighbouring manner as shown in Fig.1 may be arranged. The metallization 13 is provided on a base plate arrangement which is made of a base plate 17, an insulating substrate layer 14 and the metallization 13.

The attaching process is preferably a low temperature bonding process.

In a still further preferred embodiment, the attaching process is based on silver as bond, because Silver offers a relative high CTE of around 20 µm/m-°C and Silver does not creep at typical operating temperatures.

The metallization 13 preferably comprises copper. Since Copper offers also a high CTE of around 16 µm/m-°C, there is practically no mismatch. Therefore, the metallization layer 13 is no longer constrained as in known circuit arrangements to thin layers and its thickness may therefore be varied to provide an improved heat spread and / or to allow for an optimized electrical resistance.

In a preferred embodiment, the metallization 13 is a metallization layer in the range of 350 µm to 2 mm thickness and even more preferred in the range of 500 µm to 1.5 mm thickness.

Using a thicker metallization 13 than in conventional circuit arrangements also provides for a reduced electrical resistance.

A further benefit of a thicker metallization 13 is that its increased heat capacity provides for a more uniform temperature profile across the circuit arrangement 9 thereby leading to reduced stress and an enhanced durability of these circuit arrangements.

In a further preferred embodiment, the metallization 13 comprises a noble metal coating on a surface.

Such a noble metal coating inhibits oxide layers offering a superior connection, in particular in connection with a low temperature bond.

The base plate 17 is preferably made of a metallic material. In preferred embodiments the base plate 17 material comprises Copper (Cu) or Aluminium (Al). Both materials are cheap and offer a high CTE of 16 µm/m-°C (Cu) respectively 24 µm/m-°C (Al).

In the first embodiment the insulating substrate layer 14 is made of a high CTE material. The material may be an epoxy-based substrate, polymer-based substrate or the like. The insulating material shall offer a certain dielectric strength which is achieved by an appropriate selection of a material and thickness. Designing the thickness may also account for thermal conductivity.

In a preferred embodiment, the insulating substrate material is an epoxy-or polymer-based material. These epoxy- or polymer-based materials are typically made of a polymer matrix which comprises a filler material. By selection of appropriate polymers and fillers, e.g. ceramic fillers, the properties of these insulating materials may adapted to the needs in a wide range allowing for employing these materials not only in low voltage range. In a more general manner it can be stated that the polymer provides electrical isolation properties and the ability to resist thermal aging while the filler accounts for an enhanced thermal conductivity and provides a high dielectric strength. Known epoxy-based substrates are delivered e.g. by DENKA or Hitachi such as DENAK IMS or Hitachi HISET. Known polymer-based substrates are commercially available such as Bergquist Thermal Clad.

By choosing the appropriate epoxy-based or polymer-based insulating substrate, the CTE may be adapted such that it corresponds to the CTE of the metallization and / or provides for the necessary dielectric strength and / or thermal conductivity.

By corresponding it is meant that preferably it matches but it does not harm to deviate to some extent, e.g. if the CTE of the metallization is around 16 µm/m-°C, a CTE of the insulating substrate may be around 12 µm/m-°C to 20 µm/m-°C without harm.

In Fig.3 an alternative embodiment of the invention is shown. There a further metallization layer 15 provided on the insulating substrate layer 14 is attached via an attachment layer 16, e.g. a solder or bond layer 16, to a base plate 17. Such circuit arrangements are of particular interest where a plurality of substrates may be mounted onto a common base plate. In such an arrangement each substrate may be tested before a complete base plate is assembled thereby reducing the number of defective final circuit arrangements.

In this second embodiment again a die 11, typically a Si based die, is attached on a metallization 13. The metallization 13 is provided on a substrate arrangement which is made of a substrate 14, metallizations 13 and 15.

The attaching process is preferably again a low temperature bonding process.

In a still further preferred embodiment, the attaching process is based on silver as bond material, because Silver offers a relative high CTE of around 20 µm/m-°C.

The one or more substrate arrangements with its/their metallization 15 in turn is/are attached via an attachment layer 16, e.g. a solder or bond layer 16, onto a base plate 17. In order to improve the intelligibility, in the following only a single substrate is mentioned although the invention is not limited thereto.

In case the attaching process of the substrate arrangements is a bonding process it is preferably again a low temperature bonding process.

The material and the attachment process of attachment layer 16 may be chosen independently of attachment layer 12. Thereby, a further degree of design freedom is achieved allowing e.g. for selecting a material having an appropriate CTE to minimize stress between substrate 14 and base plate 17. Choosing the material of attachment layer 16 may also account for other parameters like reliability of bond wires and their connection in view of the used bond wire material, e.g. Aluminium.

In a still further preferred embodiment, the attaching process is based on silver as bond, because Silver (Ag) offers a relative high CTE of around 20 µm/m-°C and it does not creep at typical operational temperatures.

The metallization layers 13, 15 may comprise copper. Since Copper offers also a high CTE of around 16 µm/m-°C, there is practically no mismatch. Therefore, the metallization layer 13, 15 is no longer constrained as in known circuit arrangements and may be varied to provide an improved heat spread and / or allow for an optimized electrical resistance.

In a preferred embodiment, the metallization 13 is a metallization layer in the range of 350 µm to 2 mm thickness and even more preferred in arrange of 500 µm to 1.5 mm thickness.

In a further preferred embodiment, the metallization 13, 15 comprises a noble metal coating on a surface.

Such a noble metal coating inhibits oxide layers offering a superior connection, in particular in connection with a low temperature bond.

The base plate 17 is preferably also made of a metallic material. In preferred embodiments the base plate 17 material comprises Copper or Aluminium. Both materials are cheap and offer a high CTE of 16 µm/m-°C to 24 µm/m-°C.

In the second embodiment the insulating substrate layer 14 again is made of a high CTE material. The material may be an epoxy-based substrate or polymer-based substrate or the like. The insulating material shall offer a certain dielectric strength which is achieved by an appropriate selection of material and thickness. Designing the thickness may also account for thermal conductivity.

In a preferred embodiment, the insulating substrate material is made of a polymer-based or an epoxy-based material. These materials are typically made of a polymer matrix which comprises a filing material. By selection of appropriate polymers and fillers, e.g. ceramic fillers, the properties of these insulating materials may adapted to the needs in a wide range allowing for an employment of these materials not only in low voltage range.

By choosing the appropriate insulating substrate, the CTE may be adapted such that it corresponds to the CTE of the metallization.

By corresponding it is meant that preferably it matches but it does not harm to deviate, e.g. if the CTE of the metallization would be around 16 µm/m-°C, a CTE of the insulating substrate may be around 12 µm/m-°C to 20 µm/m-°C without harm.

The voltage range of these novel circuit arrangements according to Fig. 2 and Fig. 3 of the invention are subject to a range of up to 6500 Volt and above depending on the used substrate. Typically in the area of Power modules, a voltage range of up to around 1000 V to 1200 V is referred as low voltage range, while a voltage range which exceeds around 2500 V to 3300 V is referred to as high voltage range. Consequently the in-between-region is typically called medium voltage range.

In particular, if an polymer-based or epoxy-based substrate is used, the dielectric strength as one parameter limiting the voltage range, depends on various variables such as the filler material used therein, the degree of the filler itself and last but not least the thickness of the substrate.

Such polymer-based or epoxy-based substrates are already able to be used in a voltage range up to around 1200 V to 1700 V. It can be foreseen that novel filler materials under development will be able to reach even higher voltage ranges. Also an improved polymer and its structure will allow for further improvements. Still further improved manufacturing techniques will allow for an increase in thicknesses of the substrate material which again will contribute to extend this range.

It is by virtue of the new arrangement that a superior solution is presented which offers an improved durability and / or reduces costs.

### Reference signs list

- 1: die
- 2: solder
- 3: metallization
- 4: substrate
- 5: metallization
- 6: solder
- 7: base plate
- 9: circuit arrangement
- 11: die
- 12: attachment layer
- 13: metallization
- 14: insulating substrate
- 15: metallization
- 16: attachment layer
- 17: base plate

## Claims

1. A circuit arrangement (9) of a power module, the arrangement comprising: a die (11), an attachment layer (12), a metallization layer (13), an insulating substrate (14) and a base plate (17), wherein the insulating substrate (14) is made of a material providing a thermal expansion coefficient (CTE) of 10 µm/m-°C or above, wherein the attachment layer (12) is a low temperature bond.

2. The circuit arrangement (9) according to claim 1, wherein the attachment layer (12) comprises silver.

3. The circuit arrangement (9) according to one of claims 1 or 2, wherein the metallization layer (13) comprises copper.

4. The circuit arrangement (9) according to one of claims 1 to 3, wherein the metallization layer (13) has a thickness in the range of 350 µm to 2 mm

5. The circuit arrangement (9) according to one of claims 1 to 4, wherein the metallization layer (13) has a thickness in the range of 500 µm to 1.5 mm.

6. The circuit arrangement (9) according to one of claims 1 to 5, wherein the metallization layer (13) comprises a noble metal coating on a surface.

7. The circuit arrangement (9) according to one of claims 1 to 6, wherein the base plate (17) material is a metallic material.

8. The circuit arrangement (9) according to one of claims 1 to 7, wherein the base plate (17) material comprises Copper or Aluminium.

9. The circuit arrangement (9) according to one of claims 1 to 8, wherein the insulating substrate (14) is selected from a group comprising epoxy-based substrates, polymer-based substrates.

10. The circuit arrangement (9) according to one of claims 1 to 9, wherein the circuit arrangement is a low voltage power module.

11. The circuit arrangement (9) according to one of claims 1 to 10, wherein the CTE of the metallization layer (13) provides a CTE of around 16 µm/m-°C and the insulating substrate (14) provides a CTE in the range of 12 µm/m-°C to 20 µm/m-°C.
